# EUROPEAN PATENT APPLICATION

(11) **EP 3 354 767 A1**
(43) Date of publication of application: **01.08.2018**
(21) Application number: 16794201.0
(22) Date of filing: 05.02.2016
(51) Int. Cl.: C23C 14/54, C23C 14/24

(54) **FILM THICKNESS CONTROL SYSTEM, FILM THICKNESS CONTROL METHOD, VAPOR DEPOSITION DEVICE AND VAPOR DEPOSITION METHOD**

(30) Priority: 21.09.2015 CN 201510605228
(71) Applicant: BOE Technology Group Co., Ltd., Beijing 100015 (CN)
(72) Inventor: FU, Wenyue, Beijing 100176 (CN); CHEN, Liqiang, Beijing 100176 (CN); SUN, Junmin, Beijing 100176 (CN)
(74) Representative: Brötz, Helmut
(86) International application number: PCT/CN2016/073623
(87) International publication number: WO 2017/049841

(57) **Abstract**

A film thickness control system and a film thickness control method for an evaporation device, an evaporation device and an evaporation method are disclosed. The film thickness control system includes: a driving device (01), a film thickness meter (3) and a computer; the film thickness meter (3) is mounted on the driving device, connected with the computer, and configured to acquire a coordinate of a measured position of a substrate to be measured from the computer and send an actual film thickness of the measured position to the computer; and the computer is configured, when the actual film thickness does not exceed an error range of a preset film thickness, to calculate a new compensation value according to the actual film thickness, the preset film thickness and a current compensation value, and send the new compensation value to the evaporation device as reference for compensating evaporation. With the disclosed inventions, the evaporated film thickness of an organic material in an organic light-emitting diode (OLED) panel can be more accurately controlled.

## Description

### TECHNICAL FIELD

Embodiments of the present disclosure relate to a film thickness control system, a film thickness control method, an evaporation device and an evaporation method.

### BACKGROUND

In the field of display technology, an organic light-emitting diode (OLED) panel generally comprises a substrate and an organic light-emitting material layer disposed on the substrate. The organic light-emitting material layer may be formed by an evaporation process. For instance, the evaporation process of the organic light-emitting material layer may include: heating the organic light-emitting material via a heating source, and subsequently, evaporating the heated organic light-emitting material to a preset position on the substrate (the position for evaporation may be controlled by means of a mask in the evaporation process), so that the organic light-emitting material can be evaporated to the substrate according to a certain rate.

### SUMMARY

Embodiments of the present disclosure provide a film thickness control system, a film thickness control method, an evaporation device and an evaporation method, so as to accurately control the film thickness of an organic material layer during the evaporation of organic materials.

At least an embodiment of the present disclosure provides a film thickness control system for an evaporation device, comprising: a driving device, a film thickness meter and a computer; the film thickness meter is mounted on the driving device, connected with the computer, and configured to acquire a coordinate of a measured position of a substrate to be measured from the computer and send an actual film thickness of the measured position to the computer; and the computer is configured, when the actual film thickness does not exceed an error range of a preset film thickness, to calculate a new compensation value according to the actual film thickness, the preset film thickness and a current compensation value, and send the new compensation value to the evaporation device as reference for compensating evaporation.

At least an embodiment of the present disclosure provides a film thickness control method, comprising: employing a film thickness meter to measure an actual film thickness of a predetermined coordinate on a substrate to be measured, and feeding back the actual film thickness to a computer; when the computer determines that the actual film thickness exceeds an error range of a preset film thickness, calculating a new compensation value according to the actual film thickness, the preset film thickness and a current compensation value and feeding back the new compensation value to an evaporation device; and employing the evaporation device for compensating evaporation of an organic material on the predetermined coordinate according to the new compensation value.

At least an embodiment of the present disclosure provides an evaporation device, comprising: the above mentioned film thickness control system; and an evaporation cavity, wherein the driving device and the film thickness meter of the film thickness control system are disposed in the evaporation cavity.

At least an embodiment of the present disclosure provides an evaporation method, comprising: performing a first evaporation in an evaporation cavity of an evaporation device by a first compensation value, and forming a first film on a substrate via a preset organic material; measuring an actual film thickness at a preset position of the substrate in the evaporation cavity, and calculating a second compensation value according to the actual film thickness and a preset film thickness at the preset position; and performing a second evaporation in the evaporation cavity by the second compensation value, and forming a second film on the first film via the preset organic material.

### BRIEF DESCRIPTION OF THE DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.
FIG. 1a is a structured flowchart of a film thickness control system provided by an embodiment of the present disclosure;
FIG. 1b is a schematic structural view of a driving device and a film thickness meter in the film thickness control system provided by an embodiment of the present disclosure;
FIG. 1c is a schematic structural view of a driving device and a film thickness meter in another film thickness control system provided by the embodiment of the present disclosure;
FIG. 2 is a schematic diagram illustrating the process of measuring the substrate to be measured by the driving device and the film thickness meter in the film thickness control system as shown in FIG. 1;
FIG. 3 is a flowchart of a film thickness control method provided by the embodiment of the present disclosure;
FIG. 4 is a schematic top view of the substrate to be measured in an embodiment of the present disclosure;
FIG. 5 is a schematic top view of the evaporation device provided by an embodiment of the present disclosure; and
FIGS. 6a and 6b are schematic diagrams of the steps S61 and S63 in the evaporation method provided by an embodiment of the present disclosure.

### DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment(s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. Also, the terms such as "a," "an," etc., are not intended to limit the amount, but indicate the existence of at least one. The terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "right," "left" and the like are only used to indicate relative position relationship, and when the position of the object which is described is changed, the relative position relationship may be changed accordingly.

In the evaporation process of an organic light-emitting material layer, a crystal oscillator is generally adopted to monitor the evaporation rate of the organic light-emitting material, but the crystal oscillator only reflects the real-time rate in the process of evaporating the organic light-emitting material to the crystal oscillator and cannot reflect the influence of such factors on the evaporation process as the change in an internal structure of a cavity (for instance, the deformation of the internal structure of the cavity due to the factors such as an external force), sensitive evaporated material, the change in a heating source, or uneven heating in a crucible, or the like.

The compensation value (also the tooling value) is a parameter for controlling the film thickness by utilization of an evaporation device. Due to the continuous consumption and the change in the chemical properties of the organic light-emitting material in the evaporation process and the change in the internal environment of an evaporation cavity in the evaporation device, a film coating test must be performed before the normal evaporation of the organic light-emitting material layer. The compensation value can be obtained after the film coating test and is equal to the display film thickness/actual film thickness, in which the display film thickness refers to the film thickness of the organic light-emitting material layer required to be obtained after evaporation, also called as preset film thickness. Subsequently, the compensation value can be utilized to carry out a coating process for the normal evaporation of the organic light-emitting material layer, and hence the film thickness of the organic light-emitting material layer can be controlled.

The inventors have noted in research that: in the current commonly used evaporation process of the organic light-emitting material layer, although parameter correction can be carried out via the compensation value obtained after the film coating test, even when same evaporation process is performed on the same substrate, the actual compensation value will also change, namely the actual compensation value may be inconsistent with the compensation value obtained after the film coating test, so the current commonly used evaporation process cannot accurately control the film thickness of the organic light-emitting material layer.

At least one embodiment of the present disclosure discloses a film thickness control system, a film thickness control method, an evaporation device and an evaporation method. Compared with the current commonly used method in which the organic light-emitting material layer is formed by one evaporation process and the compensation value obtained after the film coating test is kept unchanged in the normal evaporation process of the organic light-emitting material layer, the embodiment of the present disclosure can more accurately control the evaporated film thickness of an organic material of an OLED panel by monitoring the actual film thickness at the preset position of the evaporation cavity of the evaporation device and adjusting the compensation value according to the monitoring result in the process of forming the same organic material layer.

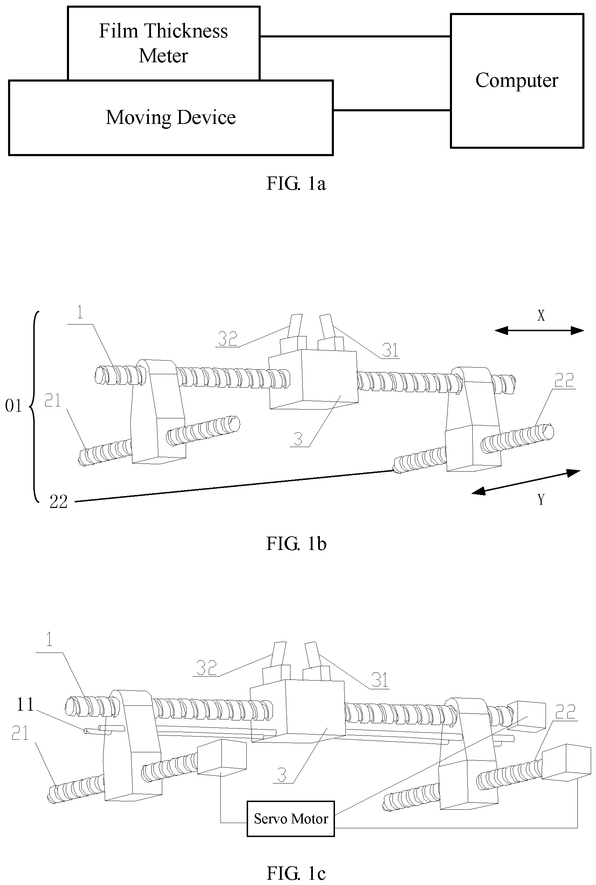

As illustrated in FIGS. 1a to 1c, the film thickness control system for the evaporation device, provided by at least one embodiment of the present disclosure, comprises: a driving device, a film thickness meter 3 and a computer (not shown in FIGS. 1b and 1c). The driving device is configured to move the film thickness meter 3 to a measured position of a substrate to be measured (not shown in the figure). The film thickness meter 3 is mounted on the driving device. For instance, the film thickness meter 3 can be movably mounted on the driving device. Moreover, the film thickness meter 3 is connected with the computer and configured to acquire a coordinate of the measured position of the substrate to be measured from the computer and send the measured actual film thickness of the measured position to the computer. The computer is configured to calculate a new compensation value according to the actual film thickness, the preset film thickness and the current compensation value when the actual film thickness does not exceed the error range of the preset film thickness (e.g., not exceeding 3%-5% of the preset film thickness) and send the new compensation value to the evaporation device as reference for compensating evaporation.

A film formed by one evaporation process is formed on the substrate to be measured. The current compensation value refers to a compensation value adopted in the evaporation process of the film. The process of employing the new compensation value as reference for compensating evaporation refers to the process of taking the new compensation value as the compensation value of the next evaporation process.

The computer may be any calculation controller for achieving a series of functions such as data processing, data acquisition, signal control, or signal transmission and reception, as long as the computer can achieve the above functions in the embodiment of the present disclosure.

By means of the film thickness control system provided by the embodiment of the present disclosure, in the evaporation process of an organic material layer (e.g., an organic light-emitting material layer), the film thickness control system is disposed in the evaporation cavity of an evaporation device; a new compensation value is calculated by comparing the actual film thickness measured by the film thickness meter and the preset film thickness in the evaporation cavity; and the evaporation device is adopted for compensating evaporation according to the new compensation value. Thus, one organic material layer can be formed by a plurality of evaporation processes by utilization of a plurality of compensation values, and hence the evaporated film thickness of the organic materials (e.g., organic light-emitting materials) of an OLED panel can be more accurately controlled. The system performs compensation for evaporation according to the new compensation value at a position at which the evaporated film thickness has not reached the lower limit of the error range of the preset film thickness (namely 95% - 97% of the preset film thickness), so that the overall film thickness of the organic materials (e.g., the organic light-emitting materials) in the OLED panel can be uniform.

An OLED panel not only includes a cathode, an anode and an organic light-emitting material layer but also may further include organic material layers such as an electron transport layer (ETL), an electron injection layer (EIL), a hole transport layer (HTL) and a hole injection layer (HIL). The film thickness control system provided by the embodiment of the present disclosure may be used for controlling the film thickness of the organic light-emitting material layer in the OLED panel and may also be used for controlling the film thickness of the above organic material layers in the OLED panel.

For instance, the driving device may include an X direction driving device and a Y direction driving device. The X direction driving device is configured to drive the film thickness meter to move along the X direction; the Y direction driving device is configured to drive the film thickness meter to move along the Y direction; and the Y direction is intersected with the X direction. For instance, the X direction and the Y direction may be consistent with the directions of the coordinate axes of the coordinate system, which is for the coordinate of the measured position of the substrate to be measured, so that data processing can be conveniently conducted. As a rectangular coordinate system is generally adopted, for instance, the X direction and the Y direction may be perpendicular to each other.

For instance, the film thickness meter can be movably disposed on the X direction driving device; or the film thickness meter can be fixedly disposed on the X direction driving device and is directly driven by the X direction driving device to move along the X direction, or the X direction driving device is driven by the Y direction driving device to move along the X direction, so that the film thickness meter can move along the X direction.

For instance, both the X direction driving device and the Y direction driving device can be achieved by lead screws. The embodiment of the present disclosure includes but not limited to the implementation.

In at least one embodiment of the present disclosure, as illustrated in FIGS. 1b and 1c, a driving device 01 (not marked in FIG. 1c) may include: an X-axis lead screw 1, a first Y-axis lead screw 21, a second Y-axis lead screw 22, and servo motors.

As illustrated in FIG. 1b, the X-axis lead screw 1 is extended along the X direction; the first Y-axis lead screw 21 and the second Y-axis lead screw 22 are extended along the Y direction; and the X direction is intersected with the Y direction. For instance, the X-axis lead screw 1 may be perpendicular to the first Y-axis lead screw 21 and the second Y-axis lead screw 22; both ends of the X-axis lead screw 1 are respectively movably mounted on the first Y-axis lead screw 21 and the second Y-axis lead screw 22; the film thickness meter 3 is movably mounted on the X-axis lead screw 1; and the servo motors are connected with the computer and configured to control the first Y-axis lead screw 21 and the second Y-axis lead screw 22 to drive the X-axis lead screw 1 to move along the Y direction according to a computer instruction, and control the X-axis lead screw 1 to drive the film thickness meter 3 to move along the X direction. By adoption of the driving device as shown in FIG. 1b, the positioning accuracy in the process of moving the film thickness meter to the preset position can be improved.

The servo motor is a high-accuracy motion system controlled by an external signal (e.g., a signal from the computer) and has the main function of driving an actuator to move by rotation. As illustrated in FIG. 1c, the servo motors are respectively disposed on bearings (not marked in FIG. 1c) on end portions of the X-axis lead screw, the first Y-axis lead screw and the second Y-axis lead screw and configured to correspondingly control the motion of the lead screws.

For instance, as illustrated in FIG. 1c, the driving device may also include guide rails 11. The servo motors are also configured to control the first Y-axis lead screw 21 and the second Y-axis lead screw 22 to drive the guide rails 11 to move along the Y direction. In this way, the film thickness meter 3 can slide along the guide rails 11, so that the film thickness meter 3 can stably move along the X direction. The number of the guide rails 11 may be at least one. Description is given with reference to FIG. 1c by taking two guide rails as an example.

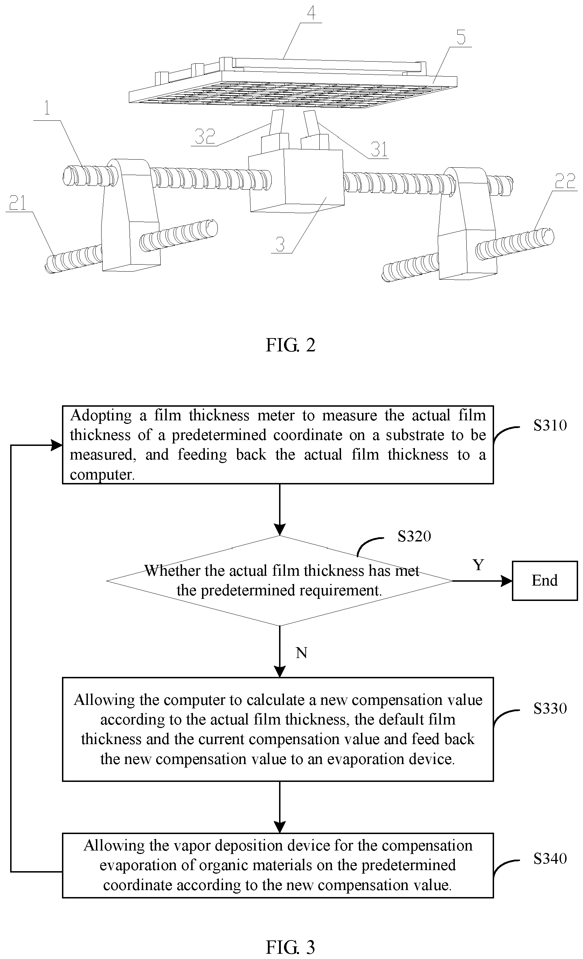

As illustrated in FIG. 2, during measurement, the driving device as shown in FIG. 1b is disposed below a mask 5; a substrate to be measured 4 is disposed on the mask 5; the computer (not shown in FIG. 2) controls the film thickness meter 3 to move to a position below a predetermined coordinate of the substrate to be measured 4; and the film thickness meter 3 monitors the film thickness through a polarizer lens 31 and an analyzer lens 32 in the film thickness meter 3. Polarized light emitted by the polarizer lens 31 is incident to the predetermined coordinate. The polarized light is reflected on the surface of a sample, and the analyzer lens 32 measures and obtains the polarization state (amplitude and phase) of reflected light. The polarization state of incident light can be acquired from the polarizer lens 31. Thus, the properties of materials can be fitted by calculating the amplitude and the phase difference between the incident light and the reflected light, and hence the actual film thickness can be obtained. Of course, the film thickness meter 3 may also adopt other thickness measuring devices commonly used in the field.

At least one embodiment of the present disclosure further provides a method for controlling the film thickness by utilization of the film thickness control system. As illustrated in FIG. 3, the method comprises the following operations.
S310: employing a film thickness meter to measure the actual film thickness of a predetermined coordinate on a substrate to be measured, and feeding back the actual film thickness to a computer.
S320: allowing the computer to determine whether the actual film thickness has exceeded the error range of the preset film thickness, and ending the entire process if not or executing the step S330 if so.
S330: when the actual film thickness exceeds the error range of the preset film thickness, allowing the computer to calculate a new compensation value according to the actual film thickness, the preset film thickness and the current compensation value and feed back the new compensation value (namely the new tooling value) to an evaporation device.
S340: allowing the evaporation device to evaporate for compensating the organic material (e.g., an organic material, such as, an organic light-emitting material, an electron transport material, an electron injection material, a hole transport material, and a hole injection material) on the predetermined coordinate according to the new compensation value. After the compensation evaporation, the process returns to the step S310, and the steps S310 to S340 are repeatedly executed until the actual film thickness reaches the preset film thickness, namely until the actual film thickness does not exceed the error range of the preset film thickness, e.g., not exceeding 3% - 5% of the preset film thickness.

In the step S310, the film thickness meter can be adopted to measure the actual film thickness of the predetermined coordinate on the substrate to be measured in an evaporation cavity of the evaporation device, which is favorable for the continuous evaporation of the organic material on the basis of the previous evaporation after calculating the new compensation value.

In the step S310, the computer is adopted to control the driving device to move the film thickness meter 3 to the predetermined coordinate.

For instance, in the step S320, the new compensation value may be calculated according to the following formula, namely Aᵢ = Aᵢ₋₁ × Tᵢ/C, in which i = 1, 2, ..., N; A₀ refers to the initial compensation value; Aᵢ refers to the new compensation value; Aᵢ₋₁ refers to the current compensation value; Tᵢ refers to the film thickness of the iₜₕ test; and C refers to the preset film thickness.

For instance, the initial compensation value may be a compensation value obtained after a film coating test.

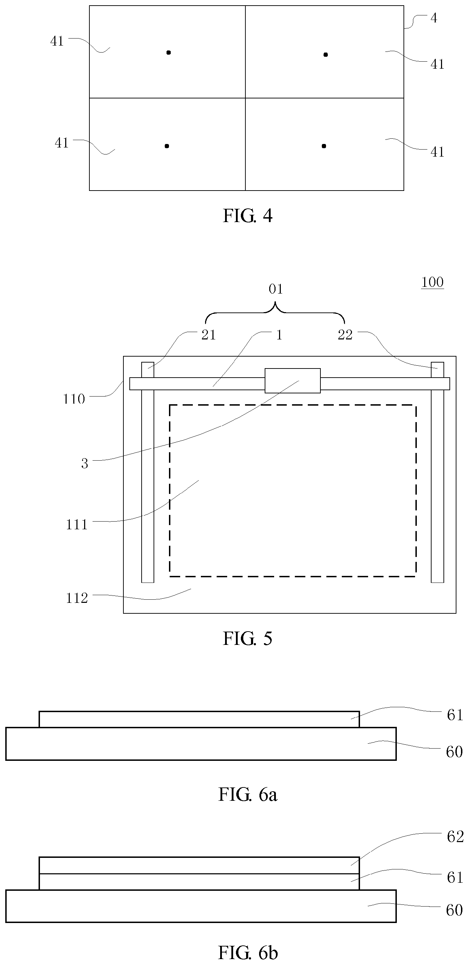

Because the display quality of the entire display panel mainly depends on the display quality of the central area of the display panel, in at least one embodiment, for instance, as illustrated in FIG. 4, the substrate to be measured 4 may include a plurality of panels 41 (the panels will be cut into individual panels in subsequent steps), and the predetermined coordinate may be the coordinate of the center (as shown by a dot in FIG. 4) of each panel on the substrate to be measured.

Because the mechanical zero of the driving device of the film thickness control system corresponds to the center of the substrate to be measured, namely the center of an XY coordinate system, the center of each panel can be easily located according to the coordinate of the center of each panel and the mechanical zero of the driving device.

At least one embodiment of the present disclosure further provides an evaporation device 100. As illustrated in FIG. 5, the evaporation device 100 comprises the film thickness control system provided by any foregoing embodiment (FIG. 5 only shows the film thickness meter 3 and the driving device 01 of the film thickness control system). The evaporation device 100 further comprises an evaporation cavity 110. The driving device 01 and the film thickness meter 3 of the film thickness control system are disposed within the evaporation cavity 110.

For instance, the evaporation cavity 110 includes an evaporation region 11 (as shown by the dotted line in FIG. 5) corresponding to the substrate to be measured (not shown in the figure) and a non-evaporation region 112. In the process of forming the organic material layer, the film thickness control system is disposed in the non-evaporation region 112 outside the evaporation region 111 in each evaporation process, so as to avoid the influence on the evaporation of the organic material layer. After one evaporation process is completed, the film thickness meter 3 of the film thickness control system is driven by the driving device 01 to move to a measured position of the substrate to be measured in the evaporation region 111, so as to measure the actual film thickness of the position. If the measured actual film thickness does not meet the requirement, next evaporation process is carried out according to the new compensation value on the basis of the previous evaporation process after the film thickness meter 3 is moved out of the evaporation region 111 (namely moved to the non-evaporation region 112).

Of course, the evaporation device may further comprise the structures such as a heating source. No further description thereto will be given here.

At least one embodiment of the present disclosure further provides an evaporation method. As illustrated in FIGS. 6a and 6b, the evaporation method comprises the following steps S61 to S63.
S61: performing a first evaporation in an evaporation cavity of an evaporation device by utilization of a first compensation value, and forming a first film 61 on a substrate 60 with a preset organic material.

In the step, the evaporation device provided by the embodiment of the present disclosure may be adopted. No further description thereto will be given here.
S62: measuring the actual film thickness of a preset position of the substrate 60 in the evaporation cavity, and calculating second compensation value according to the actual film thickness and the preset film thickness at the preset position.

In the step, the second compensation value may be obtained according to the formula in the step S320, namely second compensation value = first compensation value × actual film thickness measured in S62/preset film thickness.
S63: performing a second evaporation in the evaporation cavity by utilization of the second compensation value, and forming a second film 62 on the first film 61 with the preset organic material.

Taking the process of forming an organic light-emitting material layer as an example, if the actual film thickness at the preset position satisfies the design requirement after the step of forming the second film 62, the first film 61 and the second film 62 may be taken as the required organic light-emitting material layer on the whole; and if the actual film thickness at the preset position does not satisfy the design requirement after the step of forming the second film 62, third compensation value is calculated and continuous evaporation is performed on the basis of the second film by utilization of the third compensation value.

Of course, the method provided by the embodiment of the present disclosure may also be used for forming other organic material layers in the OLED panel, e.g., an ETL, an EIL, an HTL, and an HIL.

In the film thickness control system, the film thickness control method, the evaporation device and the evaporation method, provided by the embodiment of the present disclosure, the film thickness meter is adopted to measure the actual film thickness in the evaporation cavity of the evaporation device in the evaporation process of the organic material layer; the new compensation value is calculated by comparing the measured actual film thickness and the preset film thickness; the evaporation device is adopted for compensation evaporation according to the new compensation value; the compensation value may be adjusted in the process of forming the same organic material layer; and hence the evaporated film thickness of the OLED organic materials can be more accurately controlled.

What are described above is related to the illustrative embodiments of the disclosure only and not limitative to the scope of the disclosure; the scopes of the disclosure are defined by the accompanying claims.

The application claims priority to the Chinese patent application No. 201510605228.8, filed September 21, 2015, the entire disclosure of which is incorporated herein by reference as part of the present application.

## Claims

1. A film thickness control system for an evaporation device, comprising: a driving device, a film thickness meter and a computer, wherein
the film thickness meter is mounted on the driving device, connected with the computer, and configured to acquire a coordinate of a measured position of a substrate to be measured from the computer and send an actual film thickness of the measured position to the computer; and
the computer is configured, when the actual film thickness does not exceed an error range of a preset film thickness, to calculate a new compensation value according to the actual film thickness, the preset film thickness and a current compensation value, and send the new compensation value to the evaporation device as reference for compensating evaporation.

2. The film thickness control system according to claim 1, wherein the film thickness meter is movably mounted on the driving device.

3. The film thickness control system according to claim 1 or 2, wherein the driving device includes an X direction driving device and a Y direction driving device; the X direction driving device is configured to drive the film thickness meter to move along the X direction; the Y direction driving device is configured to drive the film thickness meter to move along the Y direction; and the Y direction is intersected with the Y direction.

4. The film thickness control system according to claim 1 or 2, wherein the driving device includes: an X-axis lead screw, a first Y-axis lead screw, a second Y-axis lead screw and servo motors, in which the X-axis lead screw is perpendicular to the first Y-axis lead screw and the second Y-axis lead screw; both ends of the X-axis lead screw are respectively movably mounted on the first Y-axis lead screw and the second Y-axis lead screw; the film thickness meter is movably mounted on the X-axis lead screw; and the servo motors are connected with the computer and configured to control the first Y-axis lead screw and the second Y-axis lead screw to drive the X-axis lead screw to move along the Y direction and control the X-axis lead screw to drive the film thickness meter to move along the X direction according to a computer instruction.

5. The film thickness control system according to claim 4, wherein the driving device further includes guide rails; and the servo motors are also configured to control the first Y-axis lead screw and the second Y-axis lead screw to drive the guide rails to move along the Y direction.

6. A film thickness control method, comprising:
employing a film thickness meter to measure an actual film thickness of a predetermined coordinate on a substrate to be measured, and feeding back the actual film thickness to a computer;
when the computer determines that the actual film thickness exceeds an error range of a preset film thickness, calculating a new compensation value according to the actual film thickness, the preset film thickness and a current compensation value and feeding back the new compensation value to an evaporation device; and
employing the evaporation device for compensating evaporation of an organic material on the predetermined coordinate according to the new compensation value.

7. The film thickness control method according to claim 6, wherein the organic material is an organic light-emitting material.

8. The film thickness control method according to claim 6 or 7, wherein the above operations are repeatedly executed until the actual film thickness meets a predetermined requirement.

9. The film thickness control method according to any one of claims 6 to 8, wherein the film thickness meter is adopted to measure the actual film thickness of the predetermined coordinate on the substrate to be measured in an evaporation cavity of the evaporation device.

10. The film thickness control method according to any one of claims 6 to 9, wherein the computer is configured to control the driving device to move the film thickness meter to the predetermined coordinate.

11. The film thickness control method according to any one of claims 6 to 10, wherein the new compensation value is calculated according to Aᵢ = Aᵢ₋₁ × Tᵢ/C, in which i = 1, 2, ..., N; A₀ refers to an initial compensation value; Aᵢ refers to the new compensation value; Aᵢ₋₁ refers to the current compensation value; Tᵢ refers to the film thickness of the iₜₕ test; and C refers to the preset film thickness.

12. The film thickness control method according to any one of claims 6 to 11, wherein the substrate to be measured includes a plurality of panels; and the predetermined coordinate is the coordinate of a center of each panel on the substrate to be measured.

13. An evaporation device, comprising:
the film thickness control system according to any one of claims 1 to 5; and
an evaporation cavity, wherein the driving device and the film thickness meter of the film thickness control system are disposed in the evaporation cavity.

14. An evaporation method, comprising:
performing a first evaporation in an evaporation cavity of an evaporation device by a first compensation value, and forming a first film on a substrate via a preset organic material;
measuring an actual film thickness at a preset position of the substrate in the evaporation cavity, and calculating a second compensation value according to the actual film thickness and a preset film thickness at the preset position; and
performing a second evaporation in the evaporation cavity by the second compensation value, and forming a second film on the first film via the preset organic material.
